(19) Europäisches Patentamt
European Patent Office
Office européen des brevets

(11) EP 4 137 611 A1

(12) **EUROPEAN PATENT APPLICATION**
published in accordance with Art. 153(4) EPC

(43) Date of publication:
**22.02.2023 Bulletin 2023/08**

(21) Application number: **22800997.3**

(22) Date of filing: **24.06.2022**

(51) International Patent Classification (IPC):
***C25D 3/02*** *(2006.01)* ***C25D 3/38*** *(2006.01)*
***H05K 3/10*** *(2006.01)*

(86) International application number:
**PCT/KR2022/009067**

(87) International publication number:
**WO 2023/282513 (12.01.2023 Gazette 2023/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.07.2021 KR 20210088379**

(71) Applicant: **YMT Co., Ltd.**
**Incheon 21690 (KR)**

(72) Inventor: **The designation of the inventor has not yet been filed**

(74) Representative: **Prüfer & Partner mbB**
**Patentanwälte · Rechtsanwälte**
**Sohnckestraße 12**
**81479 München (DE)**

# (54) LEVELING AGENT, AND ELECTROPLATING COMPOSITION FOR FORMING CIRCUIT PATTERNS, COMPRISING SAME

(57) Provided is a leveling agent that controls a plating process for forming a circuit pattern. The leveling agent allows the circuit pattern to have a uniform height and square shape even though the circuit pattern has various line widths. Also provided is an electroplating composition including the leveling agent.

**FIG. 1**

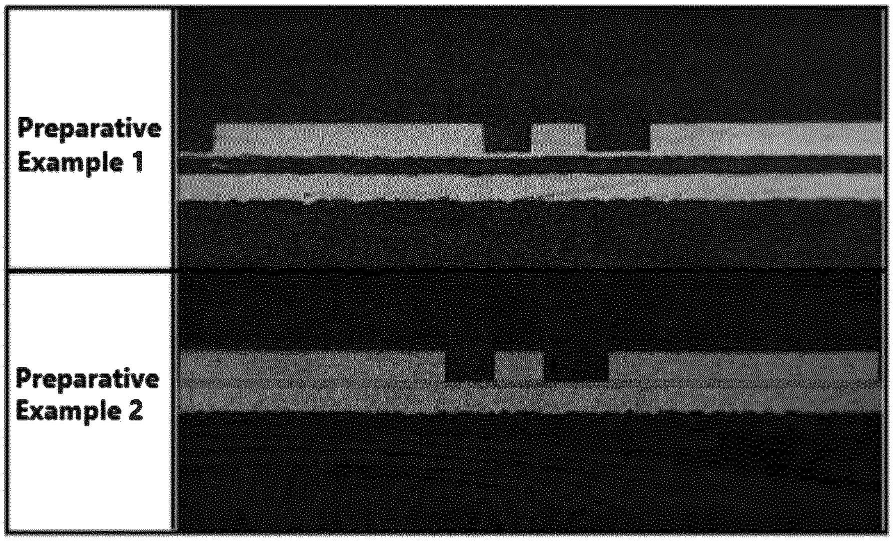


EP 4 137 611 A1

## Description

### BACKGROUND OF THE INVENTION

1. Field of the Invention

The present invention relates to a leveling agent that can be used to lower the flat ratio of a circuit pattern (*i.e.* the height deviation ratio of a circuit pattern) formed by a patterning process such as a semi-additive process (SAP) or a modified semi-additive process (MSAP) and minimize the difference in the plating thickness of the circuit pattern, and an electroplating composition including the leveling agent.

2. Description of the Related Art

With the trend toward miniaturization and integration of electronic products, printed circuit boards have also been miniaturized and integrated. Various processes for forming circuit patterns on printed circuit boards are known, for example, subtractive, semi-additive (SAP), and modified semi-additive processes (MSAP).

According to the subtractive process, electrolytic copper is used for panel plating on an existing copper foil in a copper clad laminate (CCL), resulting in an increase in the total thickness of the copper foil. Etching of the thick copper foil to form a fine circuit pattern is limited due to etching factors.

Thus, a SAP or MSAP process is currently used to form fine a circuit pattern. According to the SAP or MSAP process, a seed layer is formed by electroless plating, a photoresist (PR) circuit pattern is formed thereon, followed by electroplating to form a circuit pattern.

The circuit pattern formed by the above process may have various line widths $W_1$, $W_2$, and $W_3$, as shown in FIG. 3. The line with the narrow width $W_1$ is plated so as to have a desired height without being significantly affected by the intensity of the current density. In contrast, the lines with the wide widths $W_2$ and $W_3$ are not plated to desired heights due to the difference in the intensity of the current density, and as a result, the heights of the lines in the circuit pattern are not constant, resulting in a height deviation of the circuit pattern. As the height deviation of the circuit pattern increases, the uniformity of the circuit pattern deteriorates. This acts as a factor deteriorating the performance and reliability of a printed circuit board.

### Prior Art Documents

#### Patent Documents

(Patent Document 1) Korean Patent Publication No. 2012-0095888

### SUMMARY OF THE INVENTION

The present invention intends to provide a leveling agent that can control the height deviation of a circuit pattern during plating for forming the circuit pattern.

The present invention also intends to provide an electroplating composition including the leveling agent.

One aspect of the present invention provides a leveling agent represented by Formula 1:

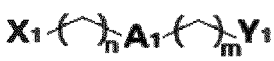

(1)

wherein $X_1$ and $Y_1$ are each independently selected from the group consisting of $C_1$-$C_{10}$ alkyl groups, $C_6$-$C_{20}$ aryl groups, and $C_2$-$C_{20}$ heteroaryl groups, $A_1$ is a single bond or is selected from the group consisting of oxygen (O), sulfur (S), carbonyl (C=O), $NR_1$, $C_1$-$C_{10}$ alkylene groups, $C_6$-$C_{20}$ arylene groups, and $C_2$-$C_{20}$ heteroarylene groups, $R_1$ is selected from the group consisting of hydrogen (H), $C_1$-$C_{10}$ alkyl groups, $C_6$-$C_{20}$ aryl groups, and $C_2$-$C_{20}$ heteroaryl groups, and n and m are each independently an integer from 0 to 10, with the proviso that at least one of n and m is 1 or more,

or including at least one structural unit selected from the group consisting of those represented by Formulae 2 to 5:

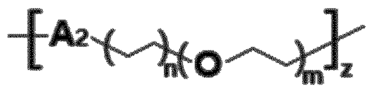 (2)

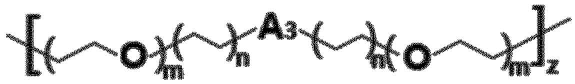 (3)

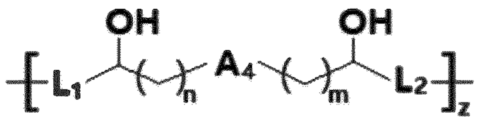 (4)

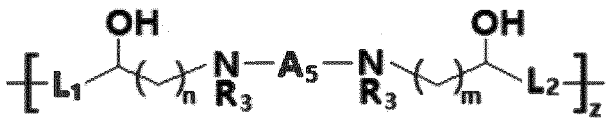 (5)

wherein $A_2$ to $A_5$ are each independently a single bond or is selected from the group consisting of oxygen (O), sulfur (S), $NR_2$, carbonyl (C=O), $C_1$-$C_{10}$ alkylene groups, $C_6$-$C_{20}$ arylene groups, and $C_2$-$C_{20}$ heteroarylene groups, $R_2$ is selected from the group consisting of hydrogen (H), $C_1$-$C_{10}$ alkyl groups, $C_6$-$C_{20}$ aryl groups, and $C_2$-$C_{20}$ heteroaryl groups, $L_1$ and $L_2$ are each independently selected from the group consisting of $C_1$-$C_{10}$ alkylene groups, $C_6$-$C_{20}$ arylene groups, and $C_2$-$C_{20}$ heteroarylene groups, each $R_3$ is independently selected from the group consisting of hydrogen (H), $C_1$-$C_{10}$ alkyl groups, $C_6$-$C_{20}$ aryl groups, and $C_2$-$C_{20}$ heteroaryl groups, n and m are each independently an integer from 0 to 10, with the proviso that at least one of n and m is 1 or more, and each z is independently an integer from 1 to 10, with the proviso that the alkyl, aryl or heteroaryl group as each of $X_1$ and $Y_1$, the alkylene, arylene or heteroarylene group as $A_1$, the alkylene, arylene or heteroarylene group as each of $A_2$ to $A_5$, the alkylene, arylene or heteroarylene group as each of $L_1$ and $L_2$, and the alkyl, aryl or heteroaryl group as each of $R_1$ to $R_3$ are each independently optionally substituted with one or more substituents selected from the group consisting of halogen groups, $C_1$-$C_{10}$ alkyl groups, $C_6$-$C_{20}$ aryl groups, and $C_2$-$C_{20}$ heteroaryl groups.

$A_1$ in Formula 1 may be selected from the group consisting of imidazole, benzimidazole, and pyridine groups.

$A_2$ in Formula 2 may be represented by S-1 or S-2:

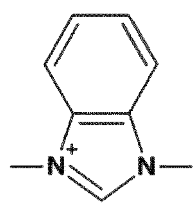

S-1

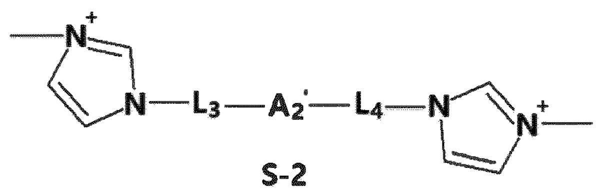

S-2

wherein $A_2$' is selected from the group consisting of $C_6$-$C_{20}$ arylene groups and $C_2$-$C_{20}$ heteroarylene groups and $L_3$ and $L_4$ are each independently a $C_1$-$C_{10}$ alkylene group.

As in Formula 3 may be $NR_2$ wherein $R_2$ may be a $C_2$-$C_{20}$ heteroaryl group.

$A_4$ in Formula 4 may be $NR_2$ wherein $R_2$ may be a $C_2$-$C_{20}$ heteroaryl group and $L_1$ and $L_2$ in Formula 4 may

each independently be a $C_1$-$C_{10}$ alkylene group.

As in Formula 5 may be carbonyl (C=O) and $L_1$ and $L_2$ in Formula 5 may each independently be a $C_1$-$C_{10}$ alkylene group.

Another aspect of the present invention provides an electroplating composition including a metal ion source and the leveling agent.

The alkyl groups are intended to include linear and branched ones. Specific examples of the alkyl groups include, but are not limited to, methyl, ethyl, propyl, butyl, and pentyl groups.

The aryl groups may be, for example, phenyl, naphthyl, biphenyl, anthracene, and phenanthrene groups but are not limited thereto.

The heteroaryl groups may be monovalent aromatic cyclic groups interrupted by at least one heteroatom such as N, O, S or F.

The alkylene groups are intended to include linear and branched ones. Specific examples of the alkylene groups include, but are not limited to, methylene, ethylene, propylene, butylene, and pentylene groups.

The arylene groups may be, for example, phenylene, naphthylene, and biphenylene groups but are not limited thereto.

The heteroarylene groups may be divalent aromatic cyclic groups interrupted by at least one heteroatom such as N, O, S or F.

The halogen groups may be, for example, fluoro, bromo, chloro, and iodo groups.

The leveling agent of the present invention can uniformly control the degree of adsorption of metal ions on a target substrate due to the presence of an alkyl structure and nitrogen atoms in the molecular structure. Therefore, metal ions can be uniformly adsorbed in a circuit pattern formed with the electroplating composition including the leveling agent according to the present invention even when different current densities are applied depending on the line widths of the circuit pattern, so that the circuit pattern has a minimal height deviation (a constant height). In conclusion, the use of the electroplating composition can provide a printed circuit board with improved performance and reliability.

## BRIEF DESCRIPTION OF THE DRAWINGS

These and/or other aspects and advantages of the invention will become apparent and more readily appreciated from the following description of the embodiments, taken in conjunction with the accompanying drawings of which:

FIGS. 1 and 2 are images for explaining Experimental Example 1; and
FIG. 3 is a reference diagram for explaining the prior art.

## DETAILED DESCRIPTION OF THE INVENTION

It should be understood that the terms and words used in the specification and the claims are not to be construed as having common and dictionary meanings but are construed as having meanings and concepts corresponding to the technical spirit of the present invention in view of the principle that the inventor can define properly the concept of the terms and words in order to describe his/her invention with the best method.

The present invention is directed to a leveling agent that can control the degree of adsorption of metal ions during plating for forming a circuit pattern, allowing the circuit pattern to have a uniform (constant) height and square shape even though the circuit pattern has various line widths, and an electroplating composition including the leveling agent.

The present invention will now be described in detail.

Specifically, the present invention provides a leveling agent represented by Formula 1:

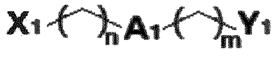 (1)

wherein $X_1$ and $Y_1$ are each independently selected from the group consisting of $C_1$-$C_{10}$ alkyl groups, $C_6$-$C_{20}$ aryl groups, and $C_2$-$C_{20}$ heteroaryl groups, $A_1$ is a single bond or is selected from the group consisting of oxygen (O), sulfur (S), carbonyl (C=O), $NR_1$, $C_1$-$C_{10}$ alkylene groups, $C_6$-$C_{20}$ arylene groups, and $C_2$-$C_{20}$ heteroarylene groups, $R_1$ is selected from the group consisting of hydrogen (H), $C_1$-$C_{10}$ alkyl groups, $C_6$-$C_{20}$ aryl groups, and $C_2$-$C_{20}$ heteroaryl groups, and n and m are each independently an integer from 0 to 10, with the proviso that at least one of n and m is 1 or more,

or including at least one structural unit selected from the group consisting of those represented by Formulae 2 to 5:

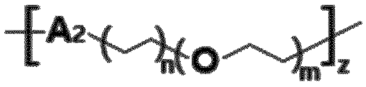

(2)

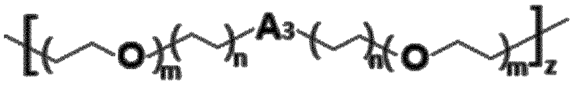

(3)

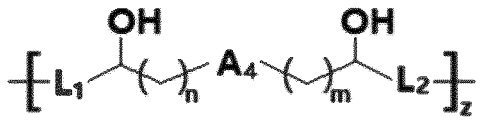

(4)

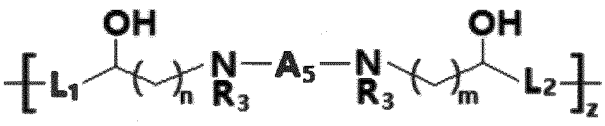

(5)

wherein $A_2$ to $A_5$ are each independently a single bond or is selected from the group consisting of oxygen (O), sulfur (S), $NR_2$, carbonyl (C=O), $C_1$-$C_{10}$ alkylene groups, $C_6$-$C_{20}$ arylene groups, and $C_2$-$C_{20}$ heteroarylene groups, $R_2$ is selected from the group consisting of hydrogen (H), $C_1$-$C_{10}$ alkyl groups, $C_6$-$C_{20}$ aryl groups, and $C_2$-$C_{20}$ heteroaryl groups, $L_1$ and $L_2$ are each independently selected from the group consisting of $C_1$-$C_{10}$ alkylene groups, $C_6$-$C_{20}$ arylene groups, and $C_2$-$C_{20}$ heteroarylene groups, each $R_3$ is independently selected from the group consisting of hydrogen (H), $C_1$-$C_{10}$ alkyl groups, $C_6$-$C_{20}$ aryl groups, and $C_2$-$C_{20}$ heteroaryl groups, n and m are each independently an integer from 0 to 10, with the proviso that at least one of n and m is 1 or more, and each z is independently an integer from 1 to 10, with the proviso that the alkyl, aryl or heteroaryl group as each of $X_1$ and $Y_1$, the alkylene, arylene or heteroarylene group as $A_1$, the alkylene, arylene or heteroarylene group as each of $A_2$ to $A_5$, the alkylene, arylene or heteroarylene group as each of $L_1$ and $L_2$, and the alkyl, aryl or heteroaryl group as each of $R_1$ to $R_3$ are each independently optionally substituted with one or more substituents selected from the group consisting of halogen groups, $C_1$-$C_{10}$ alkyl groups, $C_6$-$C_{20}$ aryl groups, and $C_2$-$C_{20}$ heteroaryl groups.

Specifically, $A_1$ in Formula 1 may be selected from the group consisting of imidazole, benzimidazole, and pyridine groups.

$A_2$ in Formula 2 may be represented by S-1 or S-2:

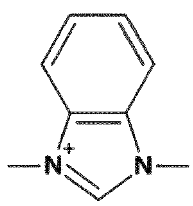

S-1

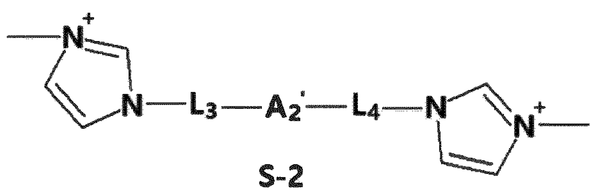

S-2

wherein $A_2$' is selected from the group consisting of $C_6$-$C_{20}$ arylene groups and $C_2$-$C_{20}$ heteroarylene groups and $L_3$ and $L_4$ are each independently a $C_1$-$C_{10}$ alkylene group. Specifically, $A_2$' may be a phenylene group and $L_3$ and $L_4$ may each independently be an ethylene or propylene group.

In the structure represented by S-1 or S-2, asterisks (*) represent bonding positions but are omitted here.

As in Formula 3 may be $NR_2$ wherein $R_2$ may be a $C_2$-$C_{20}$ heteroaryl group. Specifically, $R_2$ may be a pyridine group.

$A_4$ in Formula 4 may be $NR_2$ wherein $R_2$ may be a $C_2$-$C_{20}$ heteroaryl group. Specifically, $R_2$ may be a pyridine group. $L_1$ and $L_2$ in Formula 4 may each independently be a $C_1$-$C_{10}$ alkylene group. Specifically, $L_1$ and $L_2$ may each independently be an ethylene or propylene group.

As in Formula 5 may be carbonyl (C=O) and $L_1$ and $L_2$ in Formula 5 may each independently be a $C_1$-$C_{10}$ alkylene group. Specifically, $L_1$ and $L_2$ may each independently be an ethylene, propylene, butylene or pentylene group.

Hydrogen atoms (H) may be bonded to both ends of each of the structural units represented by Formulae 2 to 5.

In a specific embodiment, the leveling agent of the present invention may be a compound including at least one structural unit selected from those represented by C-1 to C-6:

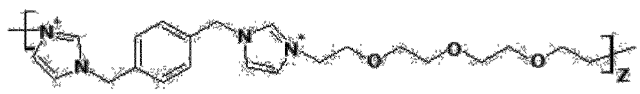

C-1

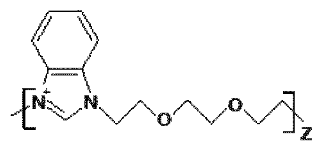

C-2

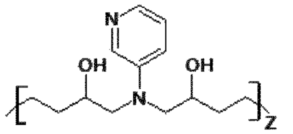

C-3

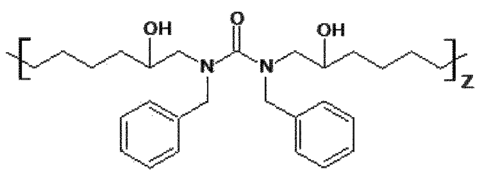

C-4

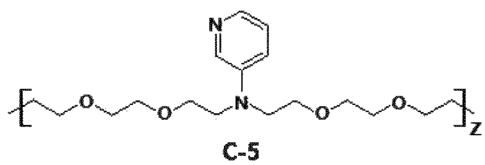

C-5

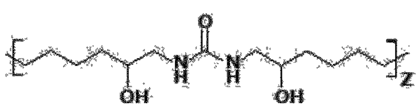

C-6

wherein each z is independently an integer from 1 to 10, but is not limited thereto.

There is no particular restriction on the method for synthesizing the leveling agent of the present invention. The leveling agent of the present invention can be synthesized with high efficiency by reacting an alkylation agent with an amine compound in the presence of a solvent. Specifically, the leveling agent of the present invention can be synthesized by dissolving an alkylation agent in a solvent, adding an amine compound to the solution, and allowing the reaction to

proceed. Here, the alkylation agent can be defined as a compound that adds an alkyl or alkylene group to the molecule of the amine compound through a substitution reaction with the amine compound.

The alkylation agent is not particularly limited and may be selected from the group consisting of 1,2-bis(2-chloroethoxy)ethane, dichloro-m-xylene, 1,3-dichloro-2-propanol, 1,4-butanediol, polypropylene glycol)diglycidyl ether, 1,6-hexanediol, and mixtures thereof.

The amine compound is not particularly limited and may be selected from the group consisting of benzimidazole, aminopyridine, 2,6-diaminopyridine, urea, thiourea, aniline, 1,3-diphenylurea, and mixtures thereof.

There is no particular restriction on the dissolution temperature of the alkylation agent in the solvent. The dissolution temperature may be 45 to 110 °C, specifically 50 to 100 °C.

The alkylation agent may react with the amine compound in a weight ratio of 4:1 to 3:2. However, there is no particular restriction on the ratio between the alkylation agent and the amine compound that react with each other.

The alkylation agent may react with the amine compound for 9 to 12 hours but the reaction time is not particularly limited.

The solvent used to dissolve the alkylation agent is not particularly limited and may be any of those commonly known in the art. The solvent may be selected from the group consisting of aqueous solvents (*e.g.*, water, purified water, and deionized water), alcoholic solvents (*e.g.,* ethanol and methanol), glycol-based solvents (*e.g.,* ethylene glycol and propylene glycol), and mixtures thereof, for example, taking into consideration the solubility of the alkylation agent and the synthesis efficiency of the leveling agent.

The leveling agent of the present invention may be a monomer obtained by the above synthetic method or a polymer obtained by polymerization of the monomer.

The present invention also provides an electroplating composition including the leveling agent. Specifically, the electroplating composition of the present invention includes the leveling agent and a metal ion source.

The leveling agent included in the electroplating composition of the present invention has been described above and thus will be omitted. The concentration (content) of the leveling agent is not particularly limited and may be 5 to 20 ml/L, specifically 8 to 12 ml/L, for example, taking into consideration the uniformity of a circuit pattern and the plating efficiency.

The metal ion source included in the electroplating composition of the present invention serves as a source for metal ions in the composition and may be any of those commonly known in the art. Specifically, the metal ion source may be a copper ion source. The concentration (content) of the metal ion source is not particularly limited and may be 50 to 250 g/L, specifically 100 to 150 g/L, for example, taking into consideration the uniformity and density of a circuit pattern.

The electroplating composition of the present invention may further include at least one component selected from the group consisting of strong acids, halogen ion sources, brighteners, and carriers, which can be used to increase the physical properties of the electroplating composition.

The electroplating composition of the present invention may further include a strong acid that serves as an electrolyte as well as a pH-adjusting agent. The strong acid may be any of those commonly known in the art. Specifically, the strong acid may be selected from the group consisting of sulfuric acid, hydrochloric acid, methanesulfonic acid, ethanesulfonic acid, propanesulfonic acid, trifluoromethanesulfonic acid, sulfonic acid, hydrobromic acid, fluoroboric acid, and mixtures thereof. The concentration (content) of the strong acid is not particularly limited and may be 50 to 250 g/L, specifically 100 to 150 g/L, for example, taking into consideration the pH of the electroplating composition.

The electroplating composition of the present invention may further include a halogen ion source that serves as a source for halogen ions in the composition. The halogen ion source may be any of those commonly known in the art, specifically a chlorine ion source. The concentration (content) of the halogen ion source is not particularly limited and may be 30 to 60 mg/L, specifically 40 to 50 mg/L, for example, taking into consideration the uniformity and density of a circuit pattern.

The electroplating composition of the present invention may further include a brightener that increases the reduction rate of metal ions for fast plating. The brightener may be any of those commonly known in the art. Specifically, the brightener may be selected from the group consisting of bis(3-sulfopropyl)disulfide (sodium salt), 3-mercapto-1-propanesulfonic acid (sodium salt), 3-amino-1-propanesulfonic acid, O-ethyl-S-(3-sulphopropyl)dithiocarbonate (sodium salt), 3-(2-benzothiazolyl-1-thio)-1-propanesulfonic acid (sodium salt), N,N-dimethyldithiocarbamic acid-(3-sulfopropyl)ester (sodium salt), and mixtures thereof. The concentration (content) of the brightener is not particularly limited and may be 0.5 to 5 ml/L, specifically 1 to 3.5 ml/L, for example, taking into consideration the plating speed of the composition.

The electroplating composition of the present invention may further include a carrier that serves to increase the surface flatness of a circuit pattern. The carrier may be any of those commonly known in the art. The concentration (content) of the carrier is not particularly limited and may be 5 to 15 ml/L, specifically 8 to 12 ml/L, for example, taking into consideration the uniformity of a circuit pattern and the plating efficiency.

The electroplating composition of the present invention can be used in various processes for forming circuit patterns. Specifically, the electroplating composition of the present invention can be used in a SAP or MSAP process

for forming a circuit pattern. However, the electroplating composition of the present invention can also be utilized in plating processes for forming plating films having uniform thicknesses as well as plating processes for forming circuit patterns.

**[Example 1]**

1,2-Bis(2-chloroethoxy)ethane (A) was added to and completely dissolved in ethylene glycol at a temperature of about 90-100 °C. Next, benzimidazole (B) was added in a weight ratio of 4:1 (A:B) relative to the 1,2-bis(2-chloroethoxy)ethane. The reaction was allowed to proceed for about 9-12 h to synthesize a leveling agent.

**[Example 2]**

A leveling agent was synthesized in the same manner as in Example 1, except that dichloro-m-xylene and aminopyridine were used instead of 1,2-bis(2-chloroethoxy)ethane and benzimidazole, respectively.

**[Example 3]**

A leveling agent was synthesized in the same manner as in Example 1, except that 1,3-dichloro-2-propanol and 2,6-diaminopyridine were used instead of 1,2-bis(2-chloroethoxy)ethane and benzimidazole, respectively.

**[Example 4]**

1,3-Dichloro-2-propanol (A) was added to water and refluxed at about 100 °C for complete dissolution. Next, 2,6-diaminopyridine (B) was added in a weight ratio of 4:1 (A:B) relative to the 1,3-dichloro-2-propanol. The reaction was allowed to proceed for about 9-12 h to synthesize a leveling agent.

**[Example 5]**

A leveling agent was synthesized in the same manner as in Example 4, except that 1,4-butanediol and urea were used instead of 1,3-dichloro-2-propanol and 2,6-diaminopyridine, respectively.

**[Example 6]**

A leveling agent was synthesized in the same manner as in Example 4, except that polypropylene glycol)diglycidyl ether (molecular weight: 380 g/mol) and thiourea were used instead of 1,3-dichloro-2-propanol and 2,6-diaminopyridine, respectively.

**[Example** 7]

A leveling agent was synthesized in the same manner as in Example 4, except that 1,4-butanediol and aniline were used instead of 1,3-dichloro-2-propanol and 2,6-diaminopyridine, respectively.

**[Example 8]**

1,3-Dichloro-2-propanol (A) was added to and completely dissolved in methanol at a temperature of about 50-70 °C. Next, aniline (B) was added in a weight ratio of 4:1 (A:B) relative to the 1,3-dichloro-2-propanol. The reaction was allowed to proceed for about 9-12 h to synthesize a leveling agent.

**[Example 9]**

A leveling agent was synthesized in the same manner as in Example 8, except that 1,4-butanediol and 1,3-diphenylurea were used instead of 1,3-dichloro-2-propanol and aniline, respectively.

**[Example 10]**

A leveling agent was synthesized in the same manner as in Example 8, except that 1,6-hexanediol and 1,3-diphenylurea were used instead of 1,3-dichloro-2-propanol and aniline, respectively.

**[Preparative Example 1]**

An electroplating composition including the following components was prepared: 100-150 g/L of copper sulfate pentahydrate, 100-150 g/L of sulfuric acid, 40-50 mg/L of hydrochloric acid, 1 -3.5 ml/L of bis(sodium sulfopropyl)disulfide, 10 ml/L of a carrier, and 10 ml/L of the leveling agent synthesized in Example 1.

**[Preparative Example 2]**

An electroplating composition was prepared in the same manner as in Preparative Example 1, except that the leveling agent of Example 2 was used instead of the leveling agent of Example 1.

**[Comparative Preparative Example 1]**

An electroplating composition was prepared in the same manner as in Preparative Example 1, except that 1,1'-dibenzyl-4,4'-bipyridinium dichloride hydrate was used instead of the leveling agent of Example 1.

**[Comparative Preparative Example 2]**

An electroplating composition was prepared in the same manner as in Preparative Example 1, except that Evans blue as a dye leveling agent was used instead of the leveling agent of Example 1.

**[Comparative Preparative Example 3]**

An electroplating composition was prepared in the same manner as in Preparative Example 1, except that 2-mercaptopyridine was used instead of the leveling agent of Example 1.

**[Comparative Preparative Example 4]**

An electroplating composition was prepared in the same manner as in Preparative Example 1, except that KDY2 (Dicolloy®) was used instead of the leveling agent of Example 1.

**[Experimental Example 1]**

An electroless copper seed layer was formed on a substrate, followed by a series of curing/exposure/development/etching processes to form a photoresist circuit pattern. Then, the photoresist circuit pattern was plated with each of the electroplating compositions prepared in Preparative Examples 1-2 and Comparative Preparative Examples 1-4. Thereafter, the photoresist was removed to form a copper circuit pattern. The electroplating conditions were set as follows:

- Temperature of the electroplating composition: 21-24 °C
- Stirring: 0.5-1.5 LPM/con.
- Current applied: 1-5 ASD
- Electrode: insoluble electrode

The cross-section of the copper circuit pattern was observed with an optical microscope. The results are shown in FIGS. 1 and 2.

FIG. 1 shows the circuit patterns formed with the electroplating compositions of Preparative Examples 1 and 2, each including the inventive leveling agent. As shown in FIG. 1, the thicknesses of the circuit patterns were constant irrespective of whether their line widths were narrow or wide. FIG. 2 shows the circuit patterns formed with the electroplating compositions of Comparative Preparative Examples 1-4 including none of the inventive leveling agents. In the lines with wide widths, the central portions were smaller in height than the edge portions.

**[Experimental** Example 2]

The thickness deviations of the copper circuit patterns formed in Experimental Example 1, the flatnesses of the circuit patterns at the lines with narrow widths, and the flatnesses of the circuit patterns at the lines with wide widths were calculated according to the following equations:

$$\text{Thickness deviation } (\mu m) = A\text{-}B \qquad (1)$$

$$\text{Flatness of circuit pattern at line with narrow width } (\%) = (A\text{-}B)/A \times 100 \qquad (2)$$

$$\text{Flatness of circuit pattern at line with wide width } (\%) = (C\text{-}D)/C \times 100 \qquad (3)$$

where A: Height of central portion of line with narrow width

B: Height of edge portion of line with narrow width

C: Height of central portion of line with wide width

D: Height of edge portion of line with wide width

The results are shown in Table 1.

*Table 1*

| Physical properties | Plating thickness ($\mu$m) | Thickness deviation of circuit pattern ($\mu$m) | Flatness of circuit pattem at line with narrow width (%) | Flatness of circuit pattern at line with wide width (%) |
|---|---|---|---|---|
| Preparative Example 1 | 20.1 | 0.9 | 1.5 | 1.7 |
| Preparative Example 2 | 18.3 | 0.7 | 2.1 | 2.4 |
| Comparative Preparative Example 1 | 26.6 | 3.5 | 3.3 | 9.7 |
| Comparative Preparative Example 2 | 24.2 | 2.3 | 3.9 | 9.5 |
| Comparative Preparative Example 3 | 17.1 | 2.4 | 4.5 | 11.9 |
| Comparative Preparative Example 4 | 33 | 4.9 | 3.8 | 9.3 |

As can be seen from the results in Table 1, the thickness deviations of the circuit patterns formed with the electroplating compositions of Preparative Examples 1 and 2, each including the inventive leveling agent, were smaller and the flatnesses of the circuit patterns were much lower. These results support that the use of the inventive leveling agents enables the formation of uniform circuit patterns with constant thicknesses.

## Claims

**1.** A leveling agent represented by Formula 1:

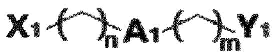

(1)

wherein $X_1$ and $Y_1$ are each independently selected from the group consisting of $C_1$-$C_{10}$ alkyl groups, $C_6$-$C_{20}$ aryl groups, and $C_2$-$C_{20}$ heteroaryl groups, $A_1$ is a single bond or is selected from the group consisting of oxygen

(O), sulfur (S), carbonyl (C=O), $NR_1$, $C_1$-$C_{10}$ alkylene groups, $C_6$-$C_{20}$ arylene groups, and $C_2$-$C_{20}$ heteroarylene groups, $R_1$ is selected from the group consisting of hydrogen (H), $C_1$-$C_{10}$ alkyl groups, $C_6$-$C_{20}$ aryl groups, and $C_2$-$C_{20}$ heteroaryl groups, and n and m are each independently an integer from 0 to 10, with the proviso that at least one of n and m is 1 or more,

or comprising at least one structural unit selected from the group consisting of those represented by Formulae 2 to 5:

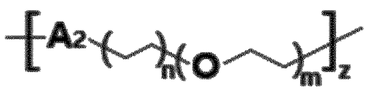

(2)

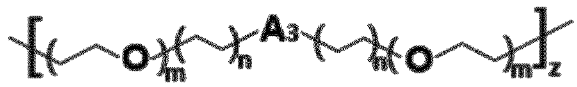

(3)

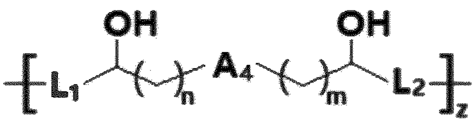

(4)

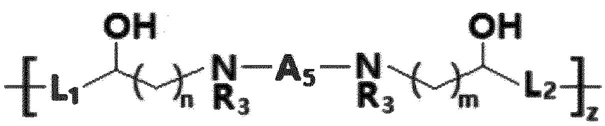

(5)

wherein $A_2$ to $A_5$ are each independently a single bond or is selected from the group consisting of oxygen (O), sulfur (S), $NR_2$, carbonyl (C=O), $C_1$-$C_{10}$ alkylene groups, $C_6$-$C_{20}$ arylene groups, and $C_2$-$C_{20}$ heteroarylene groups, $R_2$ is selected from the group consisting of hydrogen (H), $C_1$-$C_{10}$ alkyl groups, $C_6$-$C_{20}$ aryl groups, and $C_2$-$C_{20}$ heteroaryl groups, $L_1$ and $L_2$ are each independently selected from the group consisting of $C_1$-$C_{10}$ alkylene groups, $C_6$-$C_{20}$ arylene groups, and $C_2$-$C_{20}$ heteroarylene groups, each $R_3$ is independently selected from the group consisting of hydrogen (H), $C_1$-$C_{10}$ alkyl groups, $C_6$-$C_{20}$ aryl groups, and $C_2$-$C_{20}$ heteroaryl groups, n and m are each independently an integer from 0 to 10, with the proviso that at least one of n and m is 1 or more, and each z is independently an integer from 1 to 10, with the proviso that the alkyl, aryl or heteroaryl group as each of $X_1$ and $Y_1$, the alkylene, arylene or heteroarylene group as $A_1$, the alkylene, arylene or heteroarylene group as each of $A_2$ to $A_5$, the alkylene, arylene or heteroarylene group as each of $L_1$ and $L_2$, and the alkyl, aryl or heteroaryl group as each of $R_1$ to $R_3$ are each independently optionally substituted with one or more substituents selected from the group consisting of halogen groups, $C_1$-$C_{10}$ alkyl groups, $C_6$-$C_{20}$ aryl groups, and $C_2$-$C_{20}$ heteroaryl groups.

**2.** The leveling agent according to claim 1, wherein $A_1$ in Formula 1 is selected from the group consisting of imidazole, benzimidazole, and pyridine groups.

**3.** The leveling agent according to claim 1, wherein $A_2$ in Formula 2 is represented by S-1 or S-2:

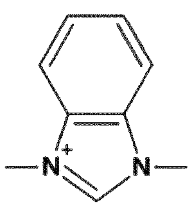

S-1

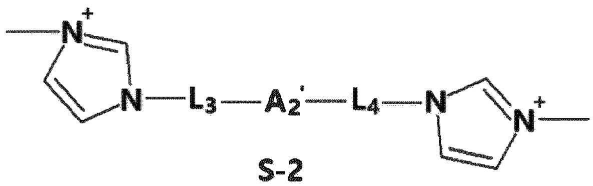

**S-2**

wherein $A_2$' is selected from the group consisting of $C_6$-$C_{20}$ arylene groups and $C_2$-$C_{20}$ heteroarylene groups and $L_3$ and $L_4$ are each independently a $C_1$-$C_{10}$ alkylene group.

**4.** The leveling agent according to claim 1, wherein $A_3$ in Formula 3 is $NR_2$ wherein $R_2$ is a $C_2$-$C_{20}$ heteroaryl group.

**5.** The leveling agent according to claim 1, wherein $A_4$ in Formula 4 is $NR_2$ wherein $R_2$ is a $C_2$-$C_{20}$ heteroaryl group and $L_1$ and $L_2$ in Formula 4 are each independently a $C_1$-$C_{10}$ alkylene group.

**6.** The leveling agent according to claim 1, wherein $A_5$ in Formula 5 is carbonyl (C=O) and $L_1$ and $L_2$ in Formula 5 are each independently a $C_1$-$C_{10}$ alkylene group.

**7.** An electroplating composition comprising a metal ion source and the leveling agent according to any one of claims 1 to 6.

**8.** The electroplating composition according to claim 7, further comprising at least one component selected from the group consisting of strong acids, halogen ion sources, brighteners, and carriers.

**9.** The electroplating composition according to claim 7, wherein the electroplating composition is used in a SAP or MSAP process for forming a circuit pattern.

FIG. 1

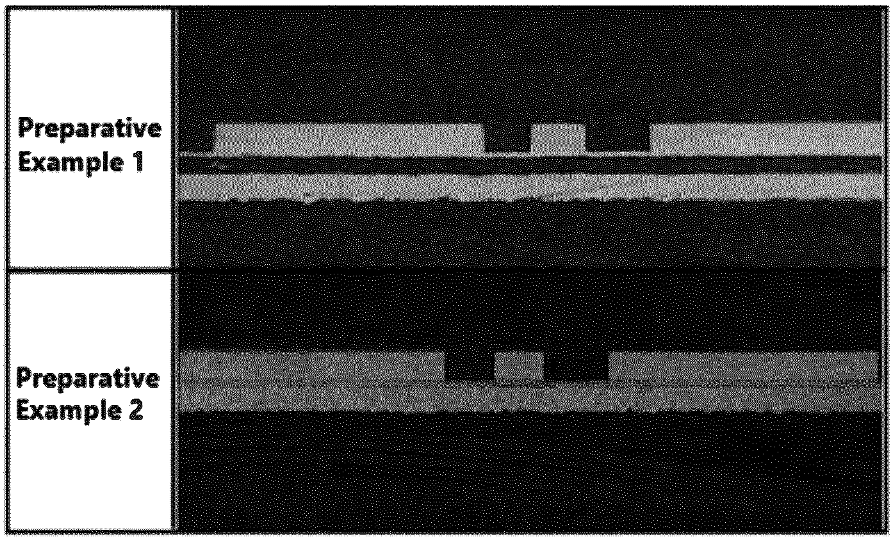
Preparative Example 1
Preparative Example 2

FIG. 2

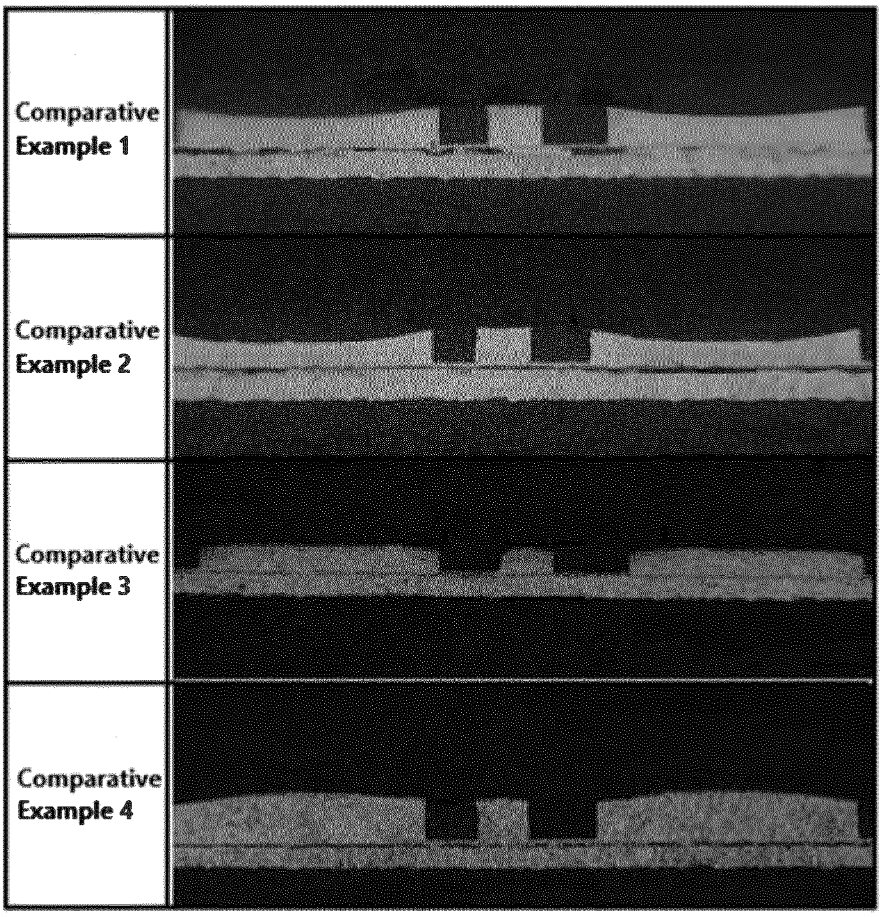
Comparative Example 1
Comparative Example 2
Comparative Example 3
Comparative Example 4

FIG. 3

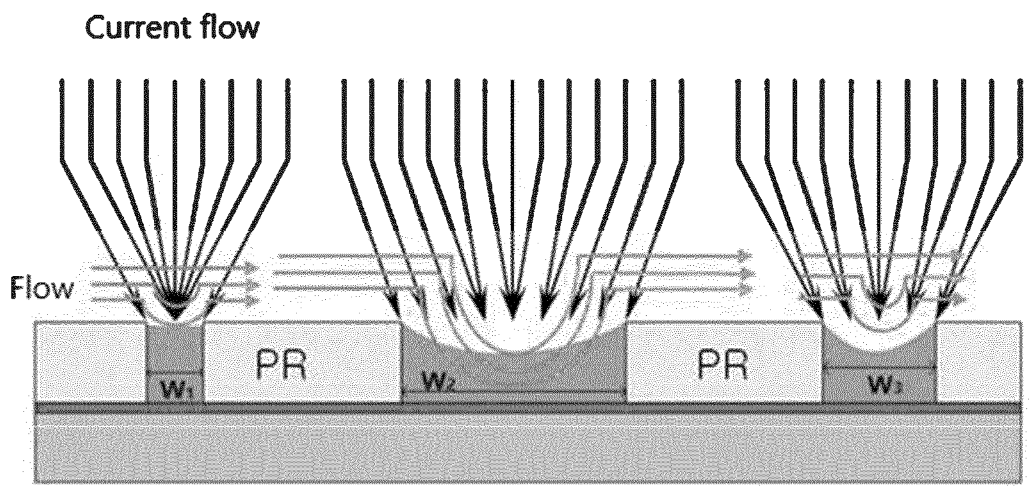

## INTERNATIONAL SEARCH REPORT

International application No.
**PCT/KR2022/009067**

**A. CLASSIFICATION OF SUBJECT MATTER**

**C25D 3/02**(2006.01)i; **C25D 3/38**(2006.01)i; **H05K 3/10**(2006.01)i

According to International Patent Classification (IPC) or to both national classification and IPC

**B. FIELDS SEARCHED**

Minimum documentation searched (classification system followed by classification symbols)

C25D 3/02(2006.01); C07D 213/24(2006.01); C08G 71/02(2006.01); C08L 75/02(2006.01); C08L 77/00(2006.01); C25D 3/12(2006.01); C25D 3/38(2006.01); C25D 3/58(2006.01); C25D 7/12(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 레벨링제(leveler), 도금(plating), 화학식(formula), 첨가물(additive)

**C. DOCUMENTS CONSIDERED TO BE RELEVANT**

| Category* | Citation of document, with indication, where appropriate, of the relevant passages | Relevant to claim No. |
|---|---|---|
| A | KR 10-2018-0009041 A (KOREA INSTITUTE OF INDUSTRIAL TECHNOLOGY) 25 January 2018 (2018-01-25) See claims 1 and 4. | 1-9 |
| A | KR 10-2012-0083390 A (ATOTECH DEUTSCHLAND GMBH) 25 July 2012 (2012-07-25) See paragraph [0143] and claim 1. | 1-9 |
| A | KR 10-2015-0088307 A (ATOTECH DEUTSCHLAND GMBH) 31 July 2015 (2015-07-31) See claim 1. | 1-9 |
| A | CN 111566259 A (ATOTECH DEUTSCHLAND GMBH) 21 August 2020 (2020-08-21) See claim 1. | 1-9 |
| A | KR 10-2018-0051865 A (SOULBRAIN CO., LTD.) 17 May 2018 (2018-05-17) See claim 1. | 1-9 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 September 2022** | **15 September 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

International application No.
**PCT/KR2022/009067**

**C. DOCUMENTS CONSIDERED TO BE RELEVANT**

| Category* | Citation of document, with indication, where appropriate, of the relevant passages | Relevant to claim No. |
|---|---|---|
| PX | KR 10-2339862 B1 (YMT CO., LTD.) 16 December 2021 (2021-12-16)<br>See claims 1-9.<br>(This document is a published earlier application that serves as a basis for claiming priority of the present international application.) | 1-9 |

Form PCT/ISA/210 (second sheet) (July 2019)

**INTERNATIONAL SEARCH REPORT**
**Information on patent family members**

International application No.
**PCT/KR2022/009067**

| Patent document cited in search report | Publication date (day/month/year) | Patent family member(s) | Publication date (day/month/year) |
|---|---|---|---|
| KR 10-2018-0009041 A | 25 January 2018 | KR 10-2023363 B1 | 24 September 2019 |
| KR 10-2012-0083390 A | 25 July 2012 | BR 112012004978 A2 | 03 May 2016 |
| | | CA 2768641 A1 | 17 March 2011 |
| | | CN 102482417 A | 30 May 2012 |
| | | CN 102482417 B | 14 January 2015 |
| | | EP 2292679 A1 | 09 March 2011 |
| | | EP 2292679 B1 | 11 March 2020 |
| | | ES 2788080 T3 | 20 October 2020 |
| | | JP 2013-503968 A | 04 February 2013 |
| | | KR 10-2193485 B1 | 22 December 2020 |
| | | TW 201126024 A | 01 August 2011 |
| | | TW I486490 B | 01 June 2015 |
| | | US 2012-0160698 A1 | 28 June 2012 |
| | | US 9322107 B2 | 26 April 2016 |
| | | WO 2011-029781 A1 | 17 March 2011 |
| KR 10-2015-0088307 A | 31 July 2015 | CN 104854265 A | 19 August 2015 |
| | | CN 104854265 B | 08 August 2017 |
| | | EP 2735627 A1 | 28 May 2014 |
| | | EP 2922985 A2 | 30 September 2015 |
| | | EP 2922985 B1 | 14 September 2016 |
| | | JP 2016-503461 A | 04 February 2016 |
| | | JP 6279598 B2 | 14 February 2018 |
| | | KR 10-2193485 B1 | 22 December 2020 |
| | | PH 12015501137 A1 | 03 August 2015 |
| | | PH 12015501137 B1 | 03 August 2015 |
| | | TW 201422854 A | 16 June 2014 |
| | | TW I600802 B | 01 October 2017 |
| | | US 2015-0299883 A1 | 22 October 2015 |
| | | US 9551080 B2 | 24 January 2017 |
| | | WO 2014-079737 A2 | 30 May 2014 |
| | | WO 2014-079737 A3 | 12 September 2014 |
| CN 111566259 A | 21 August 2020 | EP 3508620 A1 | 10 July 2019 |
| | | EP 3508620 B1 | 19 May 2021 |
| | | ES 2881029 T3 | 26 November 2021 |
| | | PT 3508620 T | 12 July 2021 |
| | | TW 201936573 A | 16 September 2019 |
| | | WO 2019-137724 A1 | 18 July 2019 |
| KR 10-2018-0051865 A | 17 May 2018 | None | |
| KR 10-2339862 B1 | 16 December 2021 | None | |

Form PCT/ISA/210 (patent family annex) (July 2019)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 20120095888